# EUROPÄISCHE PATENTSCHRIFT

(11) **EP 1 066 342 B1**
(45) Veröffentlichungstag und Bekanntmachung des Hinweises auf die Patenterteilung: **04.09.2002**
(21) Anmeldenummer: 99919113.3
(22) Anmeldetag: 12.03.1999
(51) Int. Cl.: C09B 57/10, C07F 15/00, H01G 9/20

(54) **PHOTOSENSIBILISATOR FÜR SOLARTECHNISCHE ANWENDUNGEN, VERFAHREN ZU SEINER HERSTELLUNG UND ANORDNUNG ZUR DURCHFÜHRUNG DES VERFAHRENS**
PHOTOSENSITIZER FOR APPLICATIONS IN SOLAR TECHNOLOGY, METHOD FOR THE PRODUCTION THEREOF AND CONFIGURATION TO IMPLEMENT THE METHOD
PHOTOSENSIBILISATEUR DESTINE A DES APPLICATIONS INDUSTRIELLES SOLAIRES, SON PROCEDE DE PRODUCTION ET CONFIGURATION CORRESPONDANTE

(30) Priorität: 27.03.1998 DE 19815161
(43) Veröffentlichungstag der Anmeldung: 10.01.2001
(73) Patentinhaber: Hahn-Meitner-Institut Berlin GmbH, 14109 Berlin (DE)
(72) Erfinder: FISCHER, Christian, D-14169 Berlin (DE); MICHALCZIK, Ursula, D-12249 Berlin (DE)
(74) Vertreter: Rudolph, Margit
(86) Internationale Anmeldenummer: DE9900812
(87) Internationale Veröffentlichungsnummer: WO99050358

(56) Entgegenhaltungen:
- WO-A-94/04497
- WO-A-95/29924
- WO-A-97/11955
- CHEMICAL ABSTRACTS, vol. 130, no. 12, 22. März 1999 (1999-03-22) Columbus, Ohio, US; abstract no. 162286, S. S. KULKARNI ET. AL.: "Ruthenium (II)/(III)-bipyridine complexes with four-membered sulfur donor co-ligands" Seite 1454; Spalte 1; XP002109359 & DITO: "dito" POLYHEDRON, Bd. 17, Nr. 25-26, 1998, Seiten 4365-4377, Eng.
- PATENT ABSTRACTS OF JAPAN vol. 095, no. 003, 28. April 1995 (1995-04-28) & JP 06 345414 A (MITSUBISHI PETROCHEM CO LTD), 20. Dezember 1994 (1994-12-20) in der Anmeldung erwähnt

## Beschreibung

Die Erfindung bezieht sich auf einen Photosensibilisator für solartechnische Anwendungen, der aus einem organischen Farbstoff besteht, der bezüglich seiner chemischen Zusammensetzung und seiner optischen und elektronischen Eigenschaften einer Palette aus chemisch sehr eng benachbarten, jedoch sehr unterschiedliche Sensibilisatorwirkung zeigenden organischen Farbstoffsubstanzen entstammt, sowie auf ein Verfahren zu dessen Herstellung und auf Anordnungen zur Verfahrensdurchführung.

Die Funktionsweise von solartechnischen Geräten für die Umwandlung von Lichtenergie in elektrische Energie beruht auf dem photovoltaischen Effekt an Halbleiter/Festkörper- oder Halbleiter/Elektrolyt-Kontakten. Lichtanregbare, organische Farbstoffe spielen eine bedeutende Rolle als Sensibilisatoren in solartechnischen Anwendungen, insbesondere bei Solarzellen. Unter einem "Sensibilisator" versteht man einen Stoff, der eine Empfindlichkeit eines Systems gegenüber anderen Agentien hervorruft und/oder verstärkt. Bei der spektralen oder optischen Sensibilisierung geht es um die Nutzbarmachung energetisch höherwertigen Lichts durch entsprechenden Ladungstransfer. Dabei löst nur absorbiertes Licht Wirkungen aus, reflektiertes oder transmittiertes nicht. Deshalb werden bei Solarzellen mit transparenten Halbleitern Photosensibilisatoren als dünner Farbauftrag auf diese aufgebracht. Der Halbleiter mit seinem sich an der Grenzfläche zum Elektrolyten ausbildenden elektrischen Feld übernimmt dabei die Aufgabe, die in dem Farbstoff angeregten Ladungsträger von diesem zu entfernen und durch das elektrische Feld zu transportieren. Bei der Sensibilisierung eines n-Halbleiters wird das im Farbstoff angeregte Elektron in das Leitungsband der Elektrode übernommen. Der nun oxidierte Farbstoff wird durch ein regenerierbares Redoxsystem wieder reduziert.

Das beschriebene Vorgehen ist beispielsweise aus der internationalen WO-Veröffentlichung **WO 94/04497** bekannt. Hier wird unter anderem beschrieben, wie eine Komplexverbindung für einen Ruthenium-Farbstoff RF 1 mit einem Bipyridylliganden L und einem Thiocyanat gemäß der Formel [Ru L₂ ( N C S )₂] mit L=2,2'-bipyridyl-4,4'-dicarboxylat auf chemischem Wege durch Saugfiltration bzw. Filtration isoliert werden kann. In der **WO 97/11955** wird die Herstellung von anderen Ruthenium-Komplexen durch eine chemische Synthese unter Einbeziehung von 4,4'-dicarboxy-2,2'-bipyrindin- sowie mono- und bi-dentaten Liganden beschrieben. Eine Isolierung erfolgt anschließend durch Säureausfällung bzw. Zentrifugierung. Die Niederschläge können für eine äußerliche Reinigung gewaschen werden. Eingeschlossene Verunreinigungen oder Nebenprodukte werden dabei jedoch nicht entfernt. Eine Diagnostik zur Ableitung einer Aussage über die Reinheit der synthetisierten Produkte ist ebenso wie ein Reinigungsschritt zur Verbesserung der eigentlichen Produktreinheit nicht vorgesehen.

Bei Solarzellen mit halbleitendem Titanoxid TiO₂ als Substrat, das eine große Bandlücke aufweist und nur Licht im UV-Bereich absorbiert, bewirkt ein lichtanregbarer Farbstoff aus einer organischen Mischung als Sensibilisator mit einer Absorption im sichtbaren Lichtbereich eine wesentliche Verbesserung des Wirkungsgrades der Solarzelle. Die Palette dieser bekannten organischen Farbstoffe ist relativ groß und weist viele chemisch sehr eng benachbarte Farbstoffsubstanzen auf, die jedoch als Sensibilisatoren sehr unterschiedlich wirken. Deshalb hat die Reinheit des einzusetzenden Farbstoffs einen besonderen Einfluss auf die Sensibilisierung. Dies zeigt sich in der Praxis auch darin, dass die bekannten Solarzellen mit scheinbar völlig identischem Materialaufbau trotzdem erhebliche Unterschiede in ihrem Wirkungsgrad aufweisen können.

Es zählt daher zum **Problembereich** der vorliegenden Erfindung, einen als Photosensibilisator für solartechnische Anwendungen besonders geeigneten Farbstoff zur Verfügung stellen zu können, der auch in dünnen Schichtaufträgen eine hohe und gleichbleibend reproduzierbare Effizienz von Solarzellen garantiert.

Eine **Lösung** für diesen Problembereich für Photosensibilisatoren der oben genannten Art ist gemäß der vorliegenden Erfindung darin zu sehen, dass der organische Farbstoff als hochreine Substanz dadurch erhältlich ist, dass mit dem Verfahren der Hochleistungs-Flüssigkeitschromatographie zunächst eine Identifikation der hochreinen Substanz unter den anderen organischen Farbstoffen der Palette und dann eine präparative Trennung von diesen Farbstoffen durchgeführt wird, und dass es sich bei dem hochreinen Farbstoff um einen hochreinen Ruthenium-Farbstoff RF2 mit einem Bipyridylliganden L und einem Ethylthiocarbamat gemäß der Formel handelt: Ru L₂ [(C₂ H₅ )₂ N C S₂] ₂ mit L = 2,2'- bipyridyl - 4,4' - dicarboxylat.

Der erfindungsgemäße hochreine Farbstoff, der so beschaffen ist, dass er durch eine analytische HPLC identifizierbar und durch eine präparative HPLC auch abtrennbar ist, weist keine Substanzgemische oder sehr ähnliche Substanzen auf. Diese hohe Reinheit garantiert ein optimales und vor allem auch reproduzierbares Verhalten bei der Photosensibilisierung und damit eine wesentliche Verbesserung bezüglich Höhe und Vorhersagbarkeit der Effizienz der jeweilig ausgeführten solartechnischen Anwendung, insbesondere bei Solarzellen.

Bei dem Verfahren, das die Produktion des erfindungsgemäßen Photosensibilisator-Farbstoffs in höchster, reproduzierbarer Qualität ermöglicht, handelt es sich um die sogenannte "Hochleistungs-Flüssigkeitschromatographie" (High Performance Liquid Chromatography HPLC). Dieses Verfahren dient der Trennung, d.h. Zerlegung von Gemischen in ihre Komponenten und deren qualitativer und quantitativer Analyse. Es wird in "analytische HPLC" und "präparative HPLC" als maßstabsvergrößerte HPLC unterschieden, ist an sich bekannt und soll an dieser Stelle nur kurz für die verwendete Begriffswahl erläutert werden. Bei der analytischen HPLC wird ein Lösungsmittel bzw. eine Mischung aus Lösungsmitteln durch eine Trennsäule gepumpt. Vor der Säule wird die zu analysierende Probe über eine Probenschleife in einen Flüssigkeitsstrom (mobile Phase) injiziert, der die Trennsäule durchfließt. Je nach Wechselwirkung der jeweiligen Substanz mit einem geeigneten Adsorbenz (stationäre Phase) ergeben sich für die einzelnen Probenkomponenten unterschiedliche Wanderungsgeschwindigkeiten und damit unterschiedliche Retentionszeiten. Ein Vergleich der Retentionszeiten der unbekannten Fraktionen mit denen von bekannten Standards ermöglicht die Identifikation. Die Detektion der die Säule verlassenden Fraktionen kann auf unterschiedliche Art erfolgen, beispielsweise durch Messung des optischen Absorptionsspektrums mit einem Diodenarray-Spektrometer. Im Falle der präparativen HPLC arbeitet man mit größeren Trennsäulen, um eine größere Kapazität zu erreichen. Die Dimension einer Trennsäule und damit die in einem Durchlauf zu trennende Probenmenge ist nach oben in weitem Rahmen frei wählbar. Verschiedene Ausführungen bezüglich Dimensionierung und eingefülltem Adsorbenz sind kommerziell zu beziehen. Die relevanten Fraktionen werden entweder manuell oder automatisch durch Ventilschaltungen aufgefangen.

Aus der **US-PS 4,537,759** sind die Anwendung der "LSGC" (Large Scale Gas Chromatography) und eine spezielle. Anordnung zur Durchführung des Verfahrens zur Produktion von reinem Silan (SiH₄) für Anwendungen in Solarzellen bekannt. Im Unterschied zur Flüssigkeitschromatographie wird hier zwar mit einem inerten Trägergasstrom gearbeitet. Zur näheren Erläuterung des HPLC-Verfahrens aus dem Stand der Technik im Zusammenhang mit solartechnischen Anwendungen ist diese Druckschrift jedoch gut geeignet. Daneben ist in der japanischen Offenlegungsschrift **JP-A 06345414** die Anwendung der HPLC zur Separation und Reinigung von einzelnen Fulleren-Komponenten aus Fullerenmischungen unter Benutzung von in Azeton gelösten Titanpartikeln als Adsorbenz und einem aliphatischen oder alizyklischem Kohlenwasserstoff als mobiler Phase offenbart. Derartige Komponenten (C₆₀ und C₇₀) sind ebenfalls für den Einsatz bei Solarzellen geeignet. Eine Erläuterung der HPLC-Anwendung und -Auswertung für natürliche und synthetische Textil-Farbstoffe ist dem **Aufsatz** "Identification of natural and early synthetic textile dyes with HPLC and UV/VIS-spectroscopy by diode array detection" von Ch.-H. Fischer et al. in Journal of Liquid Chromatography, 13(2), 319-331 (1990) zu entnehmen.

Im Falle der photosensibilisierenden Farbstoffe für solartechnische Anwendungen konnte bislang keine chemische Qualitätskontrolle durchgeführt werden. Störende Verunreinigungen waren bislang durch keine andere Analysemethode erkennbar. Verschiedene Untersuchungsmethoden, z.B. NMR oder optische Absorptions- oder Fluoreszenz-Spektroskopie zeigten keine Unterschiede in den Analyseergebnissen unterschiedlicher Chargen von entsprechend unreinem Farbstoffmaterial. Differenziertere Aussagen über die reale Zusammensetzung der bekannten Farbstoffe konnten nicht gemacht werden. Ebenso wurde bislang eine Reinigung des Farbstoffs in präparativem Maßstab, d.h. eine Abtrennung von Nebenprodukten, die die Effizienz der Solarzellen herabsetzen, nur durch Rekristallisation vorgenommen. Dies führte aber zu unreproduzierbarem und weniger effizientem Material.

Es zählt daher ebenfalls zum **Problembereich** der vorliegenden Erfindung, ein geeignetes Herstellungsverfahren für den erfindungsgemäßen Photosensibilisator in Form einer hochreinen Farbstoffsubstanz anzugeben, das deren Güte schnell, einfach, zuverlässig und reproduzierbar bestimmbar macht und diese auch bei der Herstellung garantiert.

Als **Lösung** für diesen Problembereich ist die Herstellung eines Photosensibilisators für solartechnische Anwendungen aus einem Ausgangsmaterial, das organische Farbstoffe enthält, die bezüglich ihrer chemischen Zusammensetzung und ihrer optischen und elektronischen Eigenschaften einer Palette aus chemisch sehr eng benachbarten, jedoch sehr unterschiedliche Sensibilisatorwirkung zeigenden organischen Farbsubstanzen entstammen, gekennzeichnet durch die Anwendung der Hochleistungs-Flüssigkeitschromatographie (HPLC) mit folgenden Verfahrensschritten :
(a) vollständige Auflösung von Ausgangsmaterial (X_{MIX}) in einem Lösungsmittel (LM) zur Bereitstellung eines Analysevolumen (V_{analyt}),
(b) Injektion des Analysevolumens (V_{analyt}) in eine mobile Phase (PHASE_{mobil}) mit einer vorgegebenen Analyse-Flussrate (F_{analyt}) aus einem organischen Lösungsmittel (A) und einer wässrigen Säure (B), deren Anteile während des Analyselaufs t_{analyt} mit einem Gradienten (ΔAB) veränderbar sind, in eine analytische Trennsäule mit einem festen Adsorbenz als stationärer Phase (PHASEₛₜₐₜ),
(c) chromatographische Analyse mit on-line-Messung der optischen Absorptionsspektren der die analytische Trennsäule nach unterschiedlichen Retentionszeiten verlassenden einzelnen Fraktionen (X_{FRAK}) des gelösten Ausgangsmaterials (X_{MIX}),
(d) Beurteilung des Analysenergebnisses hinsichtlich der Notwendigkeit einer Reinigung durch präparatives Chromatographieren (e),
(e) Auflösung von Ausgangsmaterial (X_{MIX}) in dem Lösungsmittel (LM) bis höchstens zur Sättigung zur Bereitstellung eines Präparationsvolumen (V_{präp}),
(f) Injektion des Präparationsvolumens (V_{präp}) in die mobile Phase (PHASE_{mobil}) mit einer vorgegebenen Präparations-Flussrate (F_{präp}) aus dem organischen Lösungsmittel (A) und der wässrigen Säure (B), deren Anteile während des Präparationslaufs t_{präp} mit einem Gradienten (ΔAB) veränderbar sind, in eine präparative Trennsäule mit dem festen Adsorbenz als stationärer Phase (PHASEₛₜₐₜ),
(g) Ableitung der für den Farbstoff des Photosensibilisators benötigten Hauptfraktion (X_{FRAK})_{HAUPT} im relevanten Retentionszeitfenster in eine Sammelposition und der nicht benötigten Nebenfraktionen (X_{FRAK})_{NEBEN} in eine Entsorgungsposition,
(h) Wiederholung des Prozesses (e), beginnend bei den Ausgangsparametern, bis die gewünschte Menge der benötigten Hauptfraktion (X_{FRAK})_{HAUPT} erreicht ist,
(i) mögliche Rückleitung (b) eines Anteils der gesammelten Hauptfraktion (X_{FRAK})_{HAUPT} für eine Qualitätskontrolle in die analytische Trennsäule unter analytischen Trennbedingungen und
(j) Aufarbeitung der gesammelten Hauptfraktion (X_{FRAK})_{HAUPT} zu dem benötigten hochreinen Farbstoff (X_{PUR}) und aller Nebenfraktionen (X_{FRAK})_{NEBEN} zur Entsorgung (X_{NEBEN}) bzw. Wiederverwendung (LM).

Erstmals lässt sich mit diesem Verfahren die Effizienz von nanokristallinen Solarzellen mit transparenten Halbleiterschichten zur Reinheit des verwendeten Photosensibilisators in Beziehung setzen und die Güte des Farbstoffes einfach und schnell bestimmen und bei der Herstellung sicher gewährleisten.

Vorteilhafte Ausgestaltungen des Verfahrens, insbesondere bevorzugte Parameterbelegungen, und günstige Anordnungen zur Durchführung des Verfahrens sind den nachgeordneten Unteransprüchen zu entnehmen. Um Wiederholungen zu vermeiden, wird auf den Verfahrensablauf selbst und auf die Ausgestaltungen im Zusammenhang mit den Unteransprüchen an dieser Stelle nicht weiter eingegangen und auf den speziellen Beschreibungsteil verwiesen.

**Bevorzugte Ausbildungsformen der Erfindung** werden zum vertiefenden Verständnis nachfolgend anhand der schematischen Figuren näher erläutert. Dabei zeigt:
- **Figur 1**: ein Symbolbild zum Verständnis des Charakters von hochreinen Farbstoffen, die mit dem erfindungsgemäßen Herstellungsverfahren herstellbar sind,
- **Figur 2**: ein modifiziertes Flussdiagramm des erfindungsgemäßen Herstellungsverfahren für hochreine Farbstoffe,
- **Figur 3**: verschiedene Chromatogramme,
- **Figur 4**: verschiedene Absorptionsspektren und
- **Figur 5**: ein präparatives Chromatogramm.

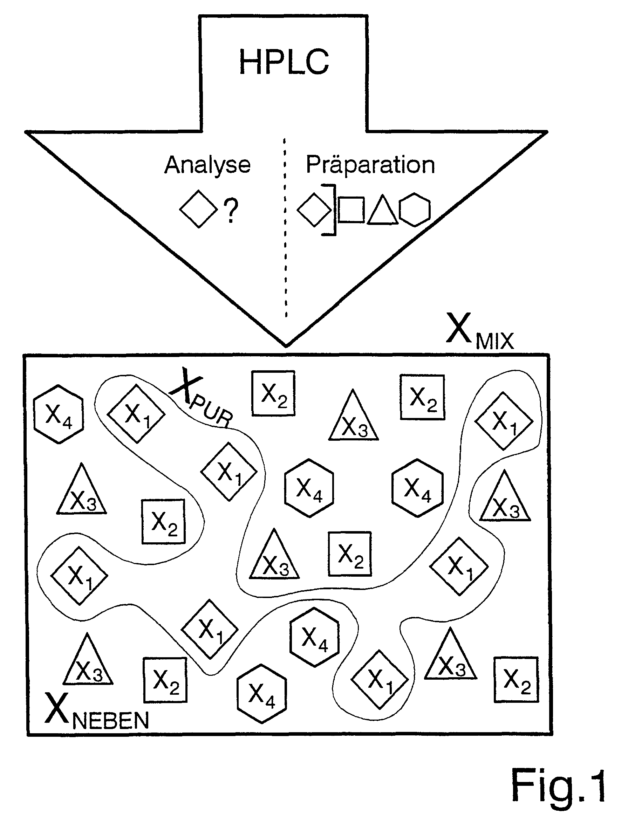

Die **Figur 1** zeigt ein Ausgangsmaterial **X**_{**MIX**}, das verschiedene Farbstoffe **X**_{**1**}, **X**_{**2**}**, X**_{**3**}**, X**_{**4**} enthält. Die meisten weisen bezüglich ihrer chemischen Zusammensetzung und ihrer optischen und elektronischen Eigenschaften große Ähnlichkeit untereinander auf, in der **Figur 1** dargestellt durch ähnliche geometrische Begrenzungen. Jedoch weist nur der Farbstoff **X**_{**1**} diejenigen charakteristischen optimalen Sensibilisator-Eigenschaften auf. Er ist mit dem Verfahren der **HPLC** bei geeigneter Parameterbelegung durch Analyse eindeutig identifizierbar und durch Präparation sicher von der übrigen Mischung abtrennbar. Alle Farbstoffmoleküle **X**_{**1**} sind also in dem Ausgangsmaterial **X**_{**MIX**} eindeutig gekennzeichnet und bilden den erfindungsgemäßen hochreinen Farbstoff **X**_{**PUR**}. Ein derartiger hochreiner Farbstoff **X**_{**PUR**} ist in seiner Zusammensetzung und damit in seinen Wirkungen von Charge zu Charge bei der Herstellung immer gleich. Er gewährleistet damit bei Verwendung als Photosensibilisator beispielsweise in Form eines hochreinen Ruthenium-Farbstoffes RF1 oder RF2 in Solarzellen als ein Einflussfaktor deren optimale Effizienz und ein hohes Maß an Reproduzierbarkeit des erzeugten Leistungsprofils.

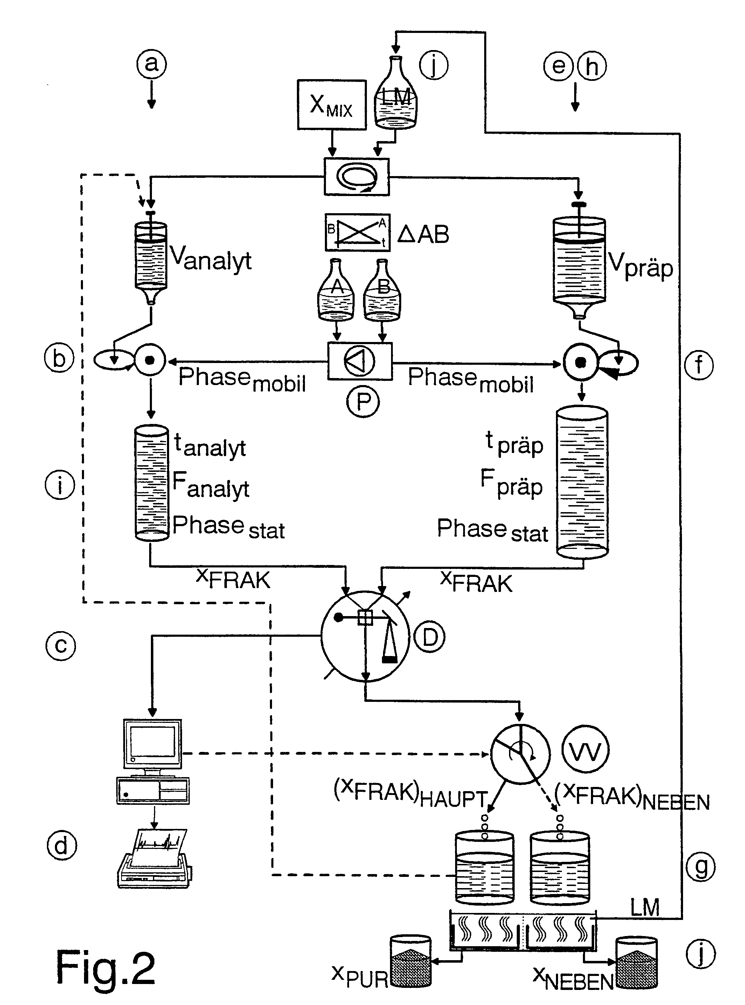

In **Figur 2** ist ein Flussdiagramm für ein bevorzugtes HPLC-Herstellungsverfahren des erfindungsgemäßen hochreinen Farbstoffs dargestellt. Dieses wird in Verbindung mit einer zur Herstellung eines der beiden oben genannten hochreinen Ruthenium-Farbstoffe optimalen Parameterbelegung im folgenden näher erläutert.

Das Ausgangsmaterial **X**_{**MIX**} wird zunächst in einem **Verfahrensschritt (a)** vollständig in einem Lösungsmittel **LM** gelöst. Als geeignetes Lösungsmittel **LM,** das das Ausgangsmaterial **X**_{**MIX**} gut löst, ohne es chemisch zu verändern, bietet sich beispielsweise für den hochreinen Ruthenium-Farbstoffs RF1 eine 1:1-Mischung (v/v) aus Methanol und Wasser an. Soll der hochreine Ruthenium-Farbstoff RF2 gelöst werden, zeigt reines Methanol, eventuell unter DMF-Zusatz, die besten Lösungseigenschaften. Das für die analytische HPLC benötigte Volumen der Lösung entspricht dem Volumen einer dünnen Probenschleife, ist mit **V**_{**analyt**} bezeichnet und beträgt im Beispiel 20 µl.

Das Analysevolumen **V**_{**analyt**} wird dann in einem **Verfahrensschritt (b)** während eines Analyselaufs **t**_{**analyt**} in eine mobile Phase (**Phase**_{mobil}) eingespritzt, die mit einer Analyse-Flussrate **F**_{**analyt**}, im Beispiel 1,5 ml/min, über eine Pumpe **P** durch eine analytische Trennsäule (hier : 120 mm x 4 mm, Fa. Knauer, Berlin) mit einer stationären Phase (**Phase**ₛₜₐₜ) (hier : Eurospher 100 C8, 5 µm) geleitet wird.

Für die Herstellung der bevorzugten hochreinen Ruthenium-Farbstoffe eignet sich als mobile Phase besonders ein Lösungsmittelgemisch aus den Komponenten **A** : Acetonitril (CH₃CN) und **B** : wässriger Schwefelsäure H₂SO₄ mit einem pH-Wert von ungefähr 4. Auch andere Säuren, z.B. Phosphor- oder Perchlorsäure, sind geeignet, als organisches Lösungsmittel können z.B. auch Methanol oder Ethanol verwendet werden. Azeton selbst eignet sich nicht so gut, da es im UV-Bereich Licht absorbiert. Um eine bessere Auftrennung zu erreichen, wird das Verhältnis von Acetonitril zu wässriger Schwefelsäure mit einem linearen Lösungsmittel-Gradienten **ΔAB** im Analyselauf **t**_{**analyt**} verändert, beispielsweise bei Einspritzung 0 min : 10% Acetonitril in 5*10⁻⁴ M wässriger H₂SO₄ linear ansteigend bis 10 min : 50% Acetonitril in 5*10⁻⁴ M wässriger H₂SO₄. Als Adsorbenz ist alkylmodifiziertes Kieselgel, z.B. C8) mit einem Korndurchmesser zwischen 5 µm und 10 um besonders geeignet.

In einem nächsten **Verfahrensschritt (c)** werden die die analytische Trennsäule nach unterschiedlichen Retentionszeiten verlassenden einzelnen Fraktionen **X**_{**FRAK**} durch eine on-line-Messung des UV/vis-Spektrums identifiziert. Die Detektion **D** erfolgt bevorzugt durch optische Absorptionsmessung mit einem Dioden-Array-Detektor.

Die manuelle oder automatische Auswertung der Analyseergebnisse erfolgt in einem **Verfahrensschritt (d).** Es ist durch Vergleich mit bekannten Ergebnissen zu entscheiden, ob die Probe ausreichend gut getrennt ist und unter Beibehaltung der Grundparameter zur Trennung der präparativen HPLC zugeführt werden kann. Ggf. kann das Ergebnis der Analyse auch so gut sein, dass eine präparative Trennung nicht erforderlich ist und die Qualität der untersuchten Substanz für einen unmittelbaren Einsatz bereits ausreicht.

Im Falle einer erforderlichen präparativen Trennung wird in einem weiteren **Verfahrensschritt (e)** in Analogie zum Verfahrensschritt (a) das Ausgangsmaterial **X**_{MIX} nun in dem Lösungsmittel **LM** gelöst. Da es bei der präparativen Trennung nunmehr auf die Quantität ankommt, kann die Konzentration der Lösung bis zur Sättigung gesteigert werden. Das Präparationsvolumen **V**_{**präp**} wird durch eine dickere Probenschleife festgelegt und beträgt bevorzugt 0,5 ml für den hochreinen Ruthenium-Farbstoff RF1 und 2 ml für den hochreinen Ruthenium-Farbstoff RF2.

Nach Umschalten auf die größere Probenschleife wird in einem nächsten **Verfahrensschritt (f)** das Präparationsvolumen **V**_{**präp**} in die mobile Phase (**Phase**_{**mobil**}) eingespritzt, die jetzt bevorzugt eine Präparations-Flussrate **F**_{**präp**} von 6,5 ml/min aufweist. Bei der präparativen Trennsäule handelt es sich im Beispiel um eine Säule 250 mm x 16 mm (Fa. Knauer, Berlin), die mit dem alkylmodifizierten Kieselgel (Eurospher 100 C8, 5 µm) als stationärer Phase (**Phase**_{**stat**}) gefüllt ist. Größere Säulen mit zum Radius quadratischem Anstieg der Trennkapazität sind für groß angelegte kommerzielle Produktionen auch möglich. Der Lösungsmittel-Gradient **ΔAB** zwischen dem Acetonitril (**A**) und der wässrigen Schwefelsäure (B) ist ebenfalls linear und hat bei der bevorzugten Herstellung des hochreinen Ruthenium-Farbstoffes RF1 den Verlauf von 0 min : 10% Acetonitril in 5*10⁻⁴ M wässriger H₂SO₄, bei 25 min : 50% Acetonitril in 5*10⁻⁴ M wässriger H₂SO₄ bis 27 min : 90% Acetonitril in 5*10⁻⁴ M wässriger H₂SO₄. Bei der Herstellung des hochreinen Ruthenium-Farbstoffes RF2 hat der Gradient **ΔAB** dagegen den Verlauf von 0 min : 20% Acetonitril in 5*10⁻⁴ M wässriger H₂SO₄, bei 45 min : 70% Acetonitril in 5*10⁻⁴ M wässriger H₂SO₄, bei 46 min : 90% Acetonitril in 5*10⁻⁴ M wässriger H₂SO₄ bis 48 min : 20% Acetonitril in 5*10⁻⁴ M wässriger H₂SO₄. Dabei hängt der längere Präparationslauf **t**_{**präp**} für den Ruthenium-Farbstoff RF2 von den wesentlich längeren Retentionszeiten ab, die auf weniger polaren Strukturen als bei dem Farbstoff RF1 beruhen.

Die für den hochreinen Farbstoff benötigte Hauptfraktion **(X**_{**FRAK**}**)**_{**HAUPT**} ist gekennzeichnet durch ihr relevantes Retentionszeitfenster. In einem weiteren **Verfahrensschritt (g)** wird sie während des Zeitfensters in eine Sammelposition abgeleitet, wohingegen alle nicht erwünschten Nebenfraktionen **(X**_{**FRAK**}**)**_{**NEBEN**} in eine Entsorgungsposition überführt werden. Dabei erfolgt die zeitabhängige Verteilung in die unterschiedlichen Positionen bevorzugt über ein Verteilerventil **VV**, das manuell oder automatisch bedienbar ist. Der folgende **Verfahrensschritt (h)** sieht einen Neubeginn des präparativen Zyklus bei Verfahrensschritt (e) vor, bis die gewünschte Menge der Hauptfraktion **(X**_{**FRAK**}**)**_{**HAUPT**} erreicht ist. Nach einer Rückstellung auf die Anfangszusammensetzung der mobilen Phase und einer Äquilibrierung der Trennsäule wird erneut injiziert.

Wenn es gewünscht wird, kann durch einfaches Rückschalten der Anlage auf die analytischen Bedingungen (b) der Erfolg der Reinigung überprüft werden. In einem **Verfahrensschritt (i)** kann deshalb die gewonnene Hauptfraktion der analytischen Trennsäule zugeführt werden. Die Detektion wird analog zu Verfahrensschritt (c) vorzugsweise ebenfalls mit dem Spektrometer **D** durchgeführt werden.

In **Figur 2** ist schematisch nur eine präparative Trennsäule vorgesehen. Es können vorteilhafterweise aber auch mehrere Trennsäulen derart angeordnet sein, dass diese parallel, aber zeitversetzt betrieben werden können. Der Detektor D arbeitet durch entsprechendes Ventilschalten immer nur an einer Trennsäule im relevanten Retentionsbereich.

Ein letzter **Verfahrensschritt (j)** beinhaltet die Aufarbeitung der gesammelten Fraktionen **(X**_{**FRAK**}**)**_{**HAUPT**} und **(X**_{**FRAK**}**)**_{**NEBEN**} zu dem benötigten hochreinen Farbstoff **X**_{**PUR**} und aller Nebenfarbstoffe **X**_{**NEBEN**} zur Entsorgung bzw. Weiterverwendung. Dazu wird das organische Lösungsmittel vollständig abgedampft, beispielsweise mit einem Rotationsverdampfer, und der Farbstoff abgetrennt. Dann wird der Farbstoffniederschlag z.B. für den hochreinen Ruthenium-Farbstoff RF1 abzentrifugiert. Das toxische Acetonitril kann durch Destillation wiedergewonnen und dem Prozess erneut zugeführt werden.

Wie in **Figur 2** angedeutet kann der gesamte Verfahrensablauf vollständig automatisiert werden. Durch Vorsehen von zumindest einer Rechnerunterstützung, einer Zeitsteuerung, eines Autosamplers und eines Schwellenschalters für das Verteilerventil kann das Verfahren inklusive Messauswertungen automatisch zyklisch ablaufen, was gerade bei Bedarf von größeren Herstellungsmengen der erfindungsgemäßen hochreinen Farbstoffsubstanz besonders okönomisch ist.

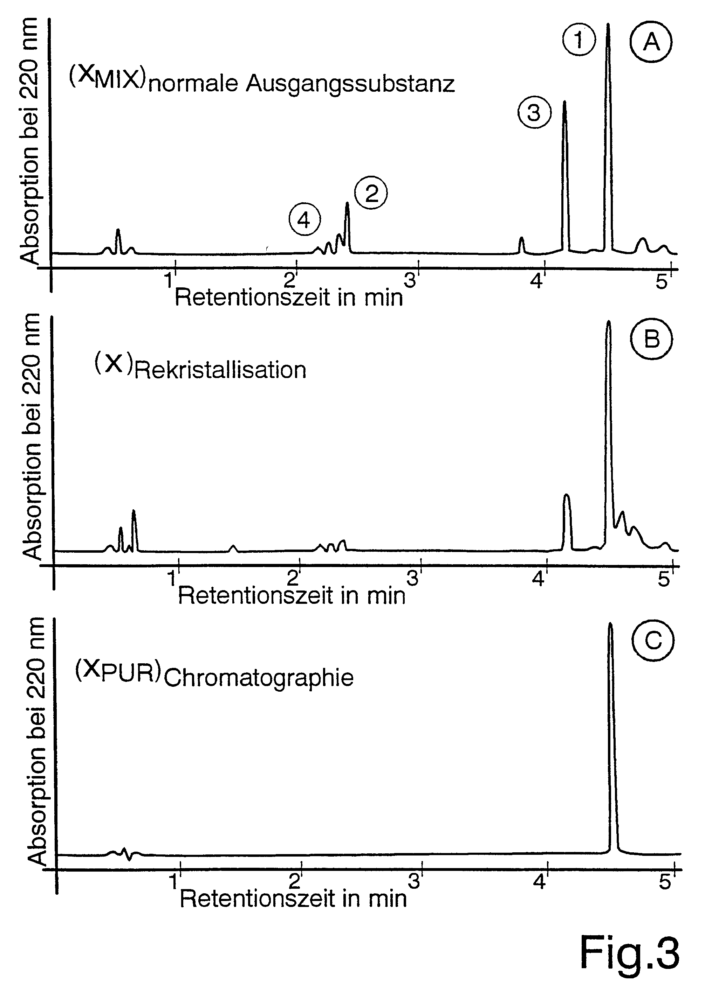

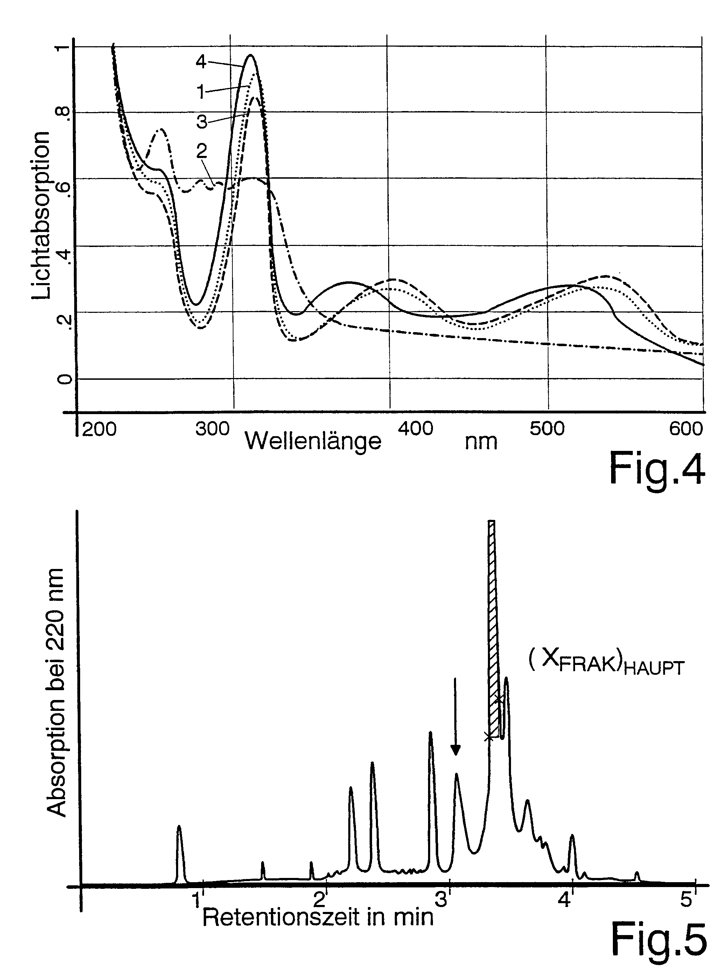

Die **Figur 3** zeigt drei verschiedene analytische **Chromatogramme A, B** und **C,** in denen jeweils die detektierte Absorption bei einer Detektionswellenlänge von 220 nm über der Retentionszeit aufgetragen ist. Zu deren näherer Erläuterung ist die **Figur 4** heranzuziehen, die die zu den chromatographischen Peaks gehörigen Absorptionsspektren zeigt. Das **Chromatogramm A** stammt von einem Ausgangsmaterial **X**_{**MIX**} zur Herstellung des hochreinen Ruthenium-Farbstoffes RF1, das relativ viele Verunreinigungen enthält. Der höchste Peak bei 4,5 min (**Peak 1**) gehört zu der erwünschten Farbstoffkomponente. Auf beiden Seiten dieses Peaks sind ungefähr ein Dutzend weitere Peaks zu erkennen. Unter diesen sind der **Peak 2** bei 2,4 min und der **Peak 3** bei 4,2 min besonders auffällig. Da das Spektrum der zu **Peak 3** zugehörigen Komponente mit dem der Komponente zu **Peak 1** weitgehend übereinstimmt und die Differenz in der Retentionszeit nur sehr klein ist, ist zu vermuten, dass es sich bei der Komponente zu **Peak 3** um eine mit sehr ähnlicher Struktur handelt, beispielsweise um ein Stereoisomer, das nur äußerst schwer analytisch zu unterscheiden ist, was bislang mit anderen Methoden auch nicht gelungen ist. Im Gegensatz dazu ist das Spektrum der Komponente zu **Peak 2** gänzlich verschieden. Die Spektren der anderen Nebenkomponenten **3** und **4** sind dem der Hauptkomponente **1** zwar sehr ähnlich, zeigen aber doch deutliche Blauverschiebungen um 15 nm bzw. 30 nm, was für die mögliche Identifikation hilfreich ist. Die weiteren kleinen Peaks bei einer Retentionszeit im Bereich von 1 min stammen von dem Lösungsmittel bzw. sind anorganische ionische Verunreinigungen. Es ist wichtig, jede Zersetzung während der Chromatographie auszuschließen. Das kann überprüft werden durch eine erneute Injizierung der gesammelten Hauptfraktion.

Das **Chromatogramm B** stammt von einem durch Rekristallisation gereinigten Ruthenium-Farbstoff RF1 und weist deutliche Nebenpeaks auf. Im Gegensatz dazu stammt das **Chromatogramm C** von dem erfindungsgemäßen hochreinen Ruthenium-Farbstoff RF1 und zeigt bis auf die Lösungsmittel-Peaks keine weiteren Nebenpeaks. Die erwünschte Hauptkomponente ist also durch geeignete Chromatographie vollständig identifiziert und separiert worden. Der Farbstoff-Reinheitsgrad ist nahezu maximal, obwohl als Ausgangsmaterial von einer relativ verunreinigten Probe (**Chromatogramm A**) ausgegangen wurde.

In **Figur 5** ist ein präparatives Chromatogramm zur Herstellung von hochreinem Ruthenium-Farbstoff RF1 dargestellt. Die Hauptfraktion **(X**_{**FRAK**}**)**_{**HAUPT**} wird zwischen den beiden Kreuzen gesammelt. Das präparative Chromatogramm zeigt das gleiche Muster wie das zugehörige analytische **Chromatogramm A** mit einer Ausnahme. Der mit einem Pfeil gekennzeichnete auffallende Peak vor dem Peak der Hauptkomponente ist neu. Er tritt nur auf, wenn größere Präparationsvolumina **V**_{**präp**} und höhere Konzentrationen injiziert werden und ist vermutlich auf Aggregation zurückzuführen. Durch eine entsprechende Kompromissfindung zwischen dem angestrebten Reinheitsgrad und der zu präparierenden Stoffmenge ist dieser Peak jedoch ohne weiteres auszugleichen.

### Bezugszeichenliste

- X_{MIX}: Ausgangsmaterial
- X₁,X₂,X₃,X₄: Farbstoff
- HPLC: High Performance Liquid Chromatography
- X_{PUR}: hochreiner Farbstoff
- RF: Ruthenium-Farbstoff
- a,b,c,....: Verfahrensschritte
- LM: Lösungsmittel
- V_{analyt}: Analysevolumen
- t_{analyt}: Analyselauf
- Phase_{mobil}: mobile Phase
- F_{analyt}: Analyse-Flussrate
- P: Pumpe
- Phaseₛₜₐₜ: stationäre Phase
- A,B: Komponenten Lösungsmittelgemisch
- ΔAB: Lösungsmittel-Gradient
- X_{FRAK}: Fraktion
- D: Detektor
- V_{präp}: Präparationsvolumen
- t_{präp}: Präparationslauf
- F_{präp}: Präparations-Flussrate
- (X_{FRAK})_{HAUPT}: Hauptfraktion
- (X_{FRAK})_{NEBEN}: Nebenfraktion
- VV: Verteilerventil
- X_{NEBEN}: Nebenfarbstoff

## Patentansprüche

1. Photosensibilisator für solartechnische Anwendungen, der aus einem organischen Farbstoff besteht, der bezüglich seiner chemischen Zusammensetzung und seiner optischen und elektronischen Eigenschaften einer Palette aus chemisch sehr eng benachbarten, jedoch sehr unterschiedliche Sensibilisatorwirkung zeigenden organischen Farbstoffsubstanzen entstammt,
**dadurch gekennzeichnet, dass**
der organische Farbstoff als hochreine Substanz (X_{PUR}) dadurch erhältlich ist, dass mit dem Verfahren der Hochleistungs-Flüssigkeitschromatographie (HPLC) zunächst eine Identifikation der hochreinen Substanz (X_{PUR}) unter den anderen organischen Farbstoffen (X_{NEBEN}) der Palette und dann eine präparative Trennung von diesen Farbstoffen (X_{NEBEN}) durchgeführt wird, und dass es sich bei dem hochreinen Farbstoff (X_{PUR}) um einen hochreinen Ruthenium-Farbstoff RF2 mit einem Bipyridylliganden L und einem Ethylthiocarbamat gemäß der Formel handelt : Ru L₂ [( C₂ H₅ )₂ N C S₂] ₂ mit L = 2,2'- bipyridyl - 4,4' - dicarboxylat.

2. Verfahren zur Herstellung eines Photosensibilisators für solartechnische Anwendungen aus einem Ausgangsmaterial, das organische Farbstoffe enthält, die bezüglich ihrer chemischen Zusammensetzung und ihrer optischen und elektronischen Eigenschaften einer Palette aus chemisch sehr eng benachbarten, jedoch sehr unterschiedliche Sensibilisatorwirkung zeigenden organischen Farbstoffsubstanzen entstammen,
**gekennzeichnet durch**
die Anwendung der Hochleistungs-Flüssigkeitschromatographie (HPLC) mit folgenden Verfahrensschritten:
(a) vollständige Auflösung von Ausgangsmaterial (X_{MIX}) in einem Lösungsmittel (LM) zur Bereitstellung eines Analysevolumen (V_{analyt}),
(b) Injektion des Analysevolumens (V_{analyt}) in eine mobile Phase (PHASE_{mobil}) mit einer vorgegebenen Analyse-Flussrate (F_{analyt}) aus einem organischen Lösungsmittel (A) und einer wässrigen Säure (B), deren Anteile während des Analyselaufs t_{analyt} mit einem Gradienten (ΔAB) veränderbar sind, in eine analytische Trennsäule mit einem festen Adsorbenz als stationärer Phase (PHASEₛₜₐₜ),
(c) chromatographische Analyse mit on-line-Messung der optischen Absorptionsspektren der die analytische Trennsäule nach unterschiedlichen Retentionszeiten verlassenden einzelnen Fraktionen (X_{FRAK}) des gelösten Ausgangsmaterials (X_{MIX}),
(d) Beurteilung des Analysenergebnisses hinsichtlich der Notwendigkeit einer Reinigung **durch** präparatives Chromatographieren (e),
(e) Auflösung von Ausgangsmaterial (X_{MIX}) in dem Lösungsmittel (LM) bis höchstens zur Sättigung zur Bereitstellung eines Präparationsvolumen (V_{präp}),
(f) Injektion des Präparationsvolumens (V_{präp}) in die mobile Phase (PHASE_{mobil}) mit einer vorgegebenen Präparations-Flussrate (F_{präp}) aus dem organischen Lösungsmittel (A) und der wässrigen Säure (B), deren Anteile während des Präparationslaufs t_{präp} mit einem Gradienten (ΔAB) veränderbar sind, in eine präparative Trennsäule mit dem festen Adsorbenz als stationärer Phase (PHASEₛₜₐₜ),
(g) Ableitung der für den Farbstoff des Photosensibilisators benötigten Hauptfraktion (X_{FRAK})_{HAUPT} im relevanten Retentionszeitfenster in eine Sammelposition und der nicht benötigten Nebenfraktionen (X_{FRAK})_{NEBEN} in eine Entsorgungsposition,
(h) Wiederholung des Prozesses (e), beginnend bei den Ausgangsparametem, bis die gewünschte Menge der benötigten Hauptfraktion (X_{FRAK})_{HAUPT} erreicht ist,
(i) mögliche Rückleitung (b) eines Anteils der gesammelten Hauptfraktion (X_{FRAK})_{HAUPT} für eine Qualitätskontrolle in die analytische Trennsäule unter analytischen Trennbedingungen und
(j) Aufarbeitung der gesammelten Hauptfraktion (X_{FRAK})_{HAUPT} zu dem benötigten hochreinen Farbstoff (X_{PUR}) und aller Nebenfraktionen (X_{FRAK})_{NEBEN} zur Entsorgung (X_{NEBEN}) bzw. Wiederverwendung (LM).

3. Verfahren zur Herstellung eines Photosensibilisators nach Anspruch 2,
**dadurch gekennzeichnet, dass**
zur Herstellung des hochreinen Ruthenium-Farbstoffs RF1 mit einem Bipyridylliganden L und einem Thiocyanat gemäß der Formel: Ru L₂ ( N C S )₂ mit L=2,2'-bipyridyl-4,4'-dicarboxylatdie Verfahrensparameter folgende Materialund Wertebelegung erhalten :
| | |
|---|---|
| Lösungsmittel LM | Methanol/ Wasser im Mischungsverhältnis 1 : 1 (v/v) |
| org. Lösungsmittel A | Acetonitril |
| wässrige Säure B | wässrige Schwefelsäure H₂SO₄ |
| Adsorbenz | alkylmodifiziertes Kieselgel |
| Analysevolumen V_{analyt} | 20 µl |
| Analyse-Flussrate F_{analyt} | 1,5 ml/min |
| Analyselauf t_{analyt} | 10 min |
| Löungsmittel-Gradient ΔAB | linear |
| | 0 min : 10% Acetonitril in 5*10⁻⁴ M wässriger H₂SO₄ |
| | 10 min : 50% Acetonitril in 5*10⁻⁴ M wässriger H₂SO₄ |
| analytische Trennsäule | 120 x 4 mm |
| Präparationsvolumen V_{präp} | 0,5 ml |
| Präp.-Flussrate F_{präp} | 6,5 ml/min |
| Präparationslauf t_{präp} | 27 min |
| Lösungsmittelgradient ΔAB | linear |
| | 0 min : 10% Acetonitril in 5*10⁻⁴ M wässriger H₂SO₄ |
| | 25 min : 50% Acetonitril in 5*10⁻⁴ M wässriger H₂SO₄ |
| | 27 min : 90% Acetonitril in 5*10⁻⁴ M wässriger H₂SO₄ |
| präp. Trennsäule | 250 mm x 16 mm. |

4. Verfahren zur Herstellung eines Photosensibilisators nach Anspruch 2,
**dadurch gekennzeichnet, dass**
zur Herstellung des hochreinen Ruthenium-Farbstoffs RF2 gemäß Anspruch 1 die Verfahrensparameter folgende Material- und Wertebelegung erhalten :
| | |
|---|---|
| Lösungsmittel LM | reines Methanol (ggf. mit DMF-Zusatz) |
| org. Lösungsmittel A | Acetonitril |
| wässrige Säure B | wässrige Schwefelsäure H₂SO₄ |
| Adsorbenz | alkylmodifiziertes Kieselgel |
| Analysevolumen V_{analyt} | 20 µl |
| Analyse-Flussrate F_{analyt} | 1,5 ml/min |
| Analyselauf t_{analyt} | 10 min |
| Lösungsmittelgradient ΔAB | linear |
| | 0 min : 10% Acetonitril in 5*10⁻⁴ M wässriger H₂SO₄ |
| | 10 min : 50% Acetonitril in 5*10⁻⁴ M wässriger H₂SO₄ |
| analytische Trennsäule | 120 x 4 mm |
| Präparationsvolumen V_{präp} | 2 ml |
| Präparations-Flussrate F_{präp} | 6,5 ml/min |
| Präparationslauf t_{präp} | 48 min |
| Lösungsmittelgradient ΔAB | linear |
| | 0 min : 20% Acetonitril in 5*10⁻⁴ M wässriger H₂SO₄ |
| | 45 min : 70% Acetonitril in 5*10⁻⁴ M wässriger H₂SO₄ |
| | 46 min : 90% Acetonitril in 5*10⁻⁴ M wässriger H₂SO₄ |
| | 48 min : 20% Acetonitril in 5*10⁻⁴ M wässriger H₂SO₄ |
| präp. Trennsäule | 250 mm x 16 mm. |

5. Anordnung zur Durchführung des Verfahren nach einem der Ansprüche 2 bis 4 zur Herstellung eines Photosensibilisators für solartechnische Anwendungen aus einem Ausgangsmaterial, das organische Farbstoffe enthält, die bezüglich ihrer chemischen Zusammensetzung und ihrer optischen und elektronischen Eigenschaften einer Palette aus chemisch sehr eng benachbarten, jedoch sehr unterschiedliche Sensibilisatorwirkung zeigenden organischen Farbstoffsubstanzen entstammen,
**dadurch gekennzeichnet, dass**
die Ableitung der für den hochreinen Farbstoff (X_{PUR}) des Photosensibilisators benötigten Hauptfraktion (X_{FRAK})_{HAUPT} im relevanten Retentionszeitfenster in eine Sammelposition über ein Verteilerventil (VV) erfolgt, das manuell oder automatisch bedienbar ist.

6. Anordnung nach Anspruch 5,
**dadurch gekennzeichnet, dass**
die analytische und die präparative HPLC mit einem Spektrometer als Detektor (D) durch on-line-Messung der optischen Absorptionsspektren der jeweiligen Fraktionen (X_{FRAK}) im UV- und visuellen Bereich durchführbar sind.

7. Anordnung nach einem der Ansprüche 5 bis 6,
**dadurch gekennzeichnet, dass**
das mehrere präparative Trennsäulen vorgesehen sind, die über eine Ventilschaltung zum Detektor (D) zeitversetzt im relevanten Retentionszeitfenster betreibbar sind.

8. Anordnung nach einem der Ansprüche 5 bis 7,
**dadurch gekennzeichnet, dass**
als Automatisierungskomponenten zumindest eine Rechnerunterstützung, eine Zeitsteuerung, ein Autosampler und ein Schwellenschalter für das Verteilventil (VV) vorgesehen sind, durch die das Verfahren vollständig automatisiert zyklisch durchführbar ist.

## Claims

1. Photosensitizer for solar-engineering applications that is composed of an organic dyestuff that, in regard to its chemical composition and its optical and electronic properties, originates from a family of chemically very closely related organic dyestuff substances, which exhibit, however very different sensitizer action, **characterized in that** the organic dyestuff is obtainable as a high-purity substance (X_{PUR}) by first identifying the high-purity substance (X_{PUR}) among the other organic dyestuffs (X_{ASSOC}) of the family by the method of high-performance liquid chromatography (HPLC) and then performing a preparative separation of said dyestuffs (X_{ASSOC}), and **in that** the high-purity dyestuff (X_{PUR}) is a high-purity ruthenium dyestuff RF2 with a bipyridyl ligand L and an ethyl thiocarbonate in accordance with the formula : Ru L₂ [(C₂H₅)₂NCS₂]₂, where L = 2,2'-bipyridyl 4,4'-dicarboxylate.

2. Method of preparing a photosensitizer for solar-engineering applications from a starting material containing organic dyestuffs that, in regard to their chemical composition and their optical and electronic properties, originate from a family of chemically very closely related organic dyestuff substances, which exhibit, however, very different sensitizer action, **characterized by** the application of high-performance liquid chromatography (HPLC) comprising the following steps in the method:
(a) complete dissolution of starting material (X_{MIX}) in a solvent (LM) in order to prepare an analysis volume (V_{analyt}),
(b) injection of the analysis volume (V_{analyt}) into a mobile phase (PHASE_{mobil}) having a predetermined analytical flowrate (F_{analyt}) composed of an organic solvent (A) and an aqueous acid (B) whose proportions can be varied during the analytical run (t_{analyt}) with a gradient (ΔAB) in an analytical separating column having a fixed adsorbent as stationary phase (PHASEₛₜₐₜ),
(c) chromatographic analysis with on-line measurement of the optical absorption spectra of the individual fractions (X_{FRAC}) of the dissolved starting material (X_{MIX}) leaving the analytical separating column after various retention times,
(d) assessment of the analytical result in regard to the need for a purification by preparative chromatography (e),
(e) dissolution of starting material (X_{MIX}) in the solvent (LM) no more than to saturation level to prepare a preparation volume (Vₚᵣₑₚ),
(f) injection of the preparation volume (Vₚᵣₑₚ) into the mobile phase (PHASE_{mobil}) having a predetermined preparation flowrate (Fₚᵣₑₚ) and composed of the organic solvent (A) and the aqueous acid (B) whose proportions can be varied during the preparation run (tₚᵣₑₚ) with a gradient (ΔAB) in a preparative separating column having the fixed adsorbent as stationery phase (PHASEₛₜₐₜ),
(g) diversion of the main fraction (X_{FRAC})_{MAIN} needed for the dyestuff of the photosensitizer in the relevant retention time window into a collecting position and the unneeded associated fractions (X_{FRAC})_{ASSOC} into a disposal position,
(h) repetition of the process (e) starting at the initial parameters until the desired amount of the needed main fraction (X_{FRAC})_{MAIN} is reached,
(i) possible feedback (b) of a portion of the collected main fraction (X_{FRAC})_{MAIN} into the analytical separating column under analytical separating conditions for a quality control, and
(j) working-up of the collected main fraction (X_{FRAC})_{MAIN} to obtain the high-purity dyestuff (X_{PUR}) needed and of all the associated fractions (X_{FRAC})_{ASSOC} for the purpose of disposal (X_{ASSOC}) or reuse (LM).

3. Method of preparing a photosensitizer according to Claim 2, **characterized in that**, to prepare the high-purity ruthenium dyestuff RF1 with a bipyridyl ligand L and a thiocyanate in accordance with the formula: Ru L₂ (NCS)₂, where L = 2,2'-bipyridyl 4,4'-dicarboxylate, the parameters of the method are assigned the following material and value specification:
| | |
|---|---|
| Solvent LM | methanol/water in a mixing ratio of 1:1 (v/v) |
| Org. solvent A | acetonitrile |
| Aqueous acid B | aqueous sulphuric acid H₂SO₄ |
| Adsorbent | alkyl-modified silica gel |
| Analysis volume V_{analyt} | 20 µl |
| Analysis flowrate F_{analyt} | 1.5 ml/min |
| Analysis run t_{analyt} | 10 min |
| Solvent gradient ΔAB | linear |
| | 0 min : 10% acetonitrile in 5*10⁻⁴ M aqueous H₂SO₄ |
| | 10 min : 50% acetonitrile in 5*10⁻⁴ M aqueous H₂SO₄ |
| Analytical separating column | 120 × 4 mm |
| Preparation volume Vₚᵣₑₚ | 0.5 ml |
| Prep. flowrate Fₚᵣₑₚ | 6.5 ml/min |
| Preparation run tₚᵣₑₚ | 27 min |
| Solvent gradient ΔAB | linear |
| | 0 min : 10% acetonitrile in 5*10⁻⁴ M aqueous H₂SO₄ |
| | 25 min : 50% acetonitrile in 5*10⁻⁴ M aqueous H₂SO₄ |
| | 27 min : 90% acetonitrile in 5*10⁻⁴ M aqueous H₂SO₄ |
| Prep. separating column | 250 mm × 16 mm. |

4. Method of preparing a photosensitizer according to Claim 2, **characterized in that**, to prepare the high-purity ruthenium dyestuff RF2 in accordance with Claim 1, the parameters of the method are assigned the following material and value specification:
| | |
|---|---|
| Solvent LM | pure methanol (optionally with DMF added) |
| Org. solvent A | acetonitrile |
| Aqueous acid B | aqueous sulphuric acid H₂SO₄ |
| Adsorbent | alkyl-modified silica gel |
| Analysis volume V_{analyt} | 20 µl |
| Analysis flowrate F_{analyt} | 1.5 ml/min |
| Analysis run t_{analyt} | 10 min |
| Solvent gradient ΔAB | linear |
| | 0 min : 10% acetonitrile in 5*10⁻⁴ M aqueous H₂SO₄ |
| | 10 min : 50% acetonitrile in 5*10⁻⁴ M aqueous H₂SO₄ |
| Analytical separating column | 120 × 4 mm |
| Preparation volume Vₚᵣₑₚ | 2 ml |
| Prep. flowrate Fₚᵣₑₚ | 6.5 ml/min |
| Preparation run tₚᵣₑₚ | 48 min |
| Solvent gradient ΔAB | linear |
| | 0 min : 20% acetonitrile in 5*10⁻⁴ M aqueous H₂SO₄ |
| | 45 min : 70% acetonitrile in 5*10⁻⁴ M aqueous H₂SO₄ |
| | 46 min : 90% acetonitrile in 5*10⁻⁴ M aqueous H₂SO₄ |
| | 48 min : 20% acetonitrile in 5*10⁻⁴ M aqueous H₂SO₄ |
| Prep. separating column | 250 mm × 16 mm. |

5. Arrangement for performing the method according to one of Claims 2 to 4, for preparing a photosensitizer for solar-engineering applications from a starting material containing organic dyestuffs that, in regard to their chemical composition and their optical and electronic properties, originate from a family of chemically very closely related organic dyestuff substances, which exhibit, however, very different sensitizer action, **characterized in that** the main fraction (X_{FRAC})_{MAIN} needed for the high-purity dyestuff (X_{PUR}) of the photosensitizer is diverted in the relevant retention time window into a collecting position via a distributor valve (VV) that can be operated manually or automatically.

6. Arrangement according to Claim 5, **characterized in that** the analytical and the preparative HPLC can be performed with a spectrometer as detector (D) by on-line measurement of the optical absorption spectra of the respective fractions (X_{FRAC}) in the UV and visual range.

7. Arrangement according to one of Claims 5 to 6, **characterized in that** a plurality of preparative separating columns are provided that can be operated by valve switching to the detector (D) in the relevant retention time window with time offset.

8. Arrangement according to one of Claims 5 to 7, **characterized in that** at least one computer aid, a time control, an autosampler and a threshold switch for the distributor valve (VV) which enable the method to be performed cyclically in a completely automated way are provided as automation components.

## Revendications

1. Photosensibilisateur pour des applications industrielles solaires, composé d'un colorant organique qui du point de vue de sa composition chimique et de scs propriétés optiques et électroniques, provient d'une palette de colorants organiques chimiquement très voisins mais ayant un effet de sensibilisation très différent,
**caractérisé en ce que**
le colorant organique est une substance très pure (X_{PUR}) obtenue **en ce que** par le procédé de chromatographie liquide à rendement poussé (HPLC) on effectue d'abord une identification de la substance très pure (X_{PUR}) parmi les autres colorants organiques (X_{NEBEN}) de la palette puis on effectue une séparation de préparation de ces colorants (X_{NEBEN}) et
le colorant très pur (X_{PUR}) est un colorant de ruthénium très pur RF2 avec un ligand de bipyridyl L et un éthylthiocarbamate selon la formule Ru L₂ [(C₂H₅)₂ N C S₂]₂, avec L = 2,2'- bipyridyl - 4,4' - dicarboxylate.

2. Procédé de fabrication d'un photosensibilisateur pour des applications industrielles solaires à partir d'une matière première contenant des matières organiques d'une palette ayant une composition chimique et des propriétés optiques électroniques, en étant très voisins chimiquement mais dont les colorants organiques ont un effet de sensibilisateur différent,
**caractérisé par**
l'application de la chromatographie liquide à rendement poussé (HPLC) selon les étapes suivantes :
a) on dissout complètement la matière du départ (X_{MIX}) dans un solvant (LM) pour obtenir un volume d'analyse (V_{analyt}),
b) on injecte le volume d'analyse (V_{analyt}) dans une phase mobile (PHA-SE_{mobil}) avec un débit d'analyse prédéterminé (F_{analyt}) formé d'un solvant organique (A) et d'un acide aqueux (B) dont les proportions sont variables pendant le déroulement de l'analyse (t_{analyt}) selon un gradient (ΔAB), dans une colonne de séparation analytique avec un adsorbant fixe comme phase stationnaire (PHA-SEₛₜₐₜ),
c) on effectue une analyse chromatographique par une mesure en ligne des spectres d'absorption optique de la colonne de séparation analytique selon les différentes fractions (X_{FRAK}) de la matière première dissoute (X_{MIX}), selon les temps de rétention différents,
d) on juge du résultat de l'analyse du point de vue de la nécessité d'un nettoyage par chromatographie préparatoire (e),
e) on dissout la matière première (X_{MIX}) dans le solvant (LM) jusqu'au maximum de la saturation pour obtenir un volume de préparation (V_{präp}),
f) on injecte le volume de préparation (V_{präp}) dans la phase mobile (PHASE_{mobil}) avec un débit de préparation prédéterminé (F_{präp}) cette phase se composant du solvant organique (A) et de l'acide aqueux (B) dont les proportions varient pendant le déroulement de la préparation (t_{prâp}) selon un gradient (ΔAB), dans une colonne de séparation de préparation avec un adsorbant fixe comme phase stationnaire (PHASEₛₜₐₜ),
g) on dérive la fraction principale (X_{FRAK})_{ILAUPT}, nécessaire pour le colorant du photosensibilisateur, dans la fenêtre de rétention caractéristique, dans une position d'accumulation et la fraction accessoire non nécessaire (X_{FRAK})_{NEBEN} dans une position d'évacuation,
h) on répète le procédé en commençant par les paramètres de sortie jusqu'à obtenir la quantité souhaitée de la fraction principale nécessaire (X_{FRAK})_{HAUPT},
i) on reconduit éventuellement (b) une partie de la fraction principale collectée (X_{FRAK})_{HAUPT} pour un contrôle de qualité dans la colonne de séparation analytique dans les conditions de séparation analytique et
j) on prépare la fraction principale collectée (X_{FRAK})_{HAUPT} pour obtenir le colorant très pur, nécessaire (X_{PUR}) et on évacue toutes les fractions auxiliaires (X_{FRAK})_{NEBEN} (X_{NEBEN}) ou en prise $$$ on voit la récupération (LM).

3. Procédé de fabrication d'un photosensibilisateur selon la revendication 2,
**caractérisé en ce que**
pour fabriquer un colorant de ruthénium très pur RF1 avec un ligand de bipyridyl L et un thiocyanate selon la formule : Ru L₂ (N C S)₂, L = 2,2' - bipyridyl - 4,4' - dicarboxylate on utilise les paramètres de procédé et les valeurs des matières suivantes :
| | |
|---|---|
| solvant LM | méthanol/eau selon un rapport de mélange 1/1 en volume |
| solvant organique A | acétonitril |
| acide aqueux B | acide sulfurique en solution H₂SO₄ |
| adsorbant | gel de silice modifiée alkyl |
| volume d'analyse V_{analyt} | 20 µl |
| débit d'analyse F_{analyt} | 1,5ml/min |
| déroulement de l'analyse t_{analyt} | 10 min |
| gradient de solvant ΔAB | linéaire |
| | 0 min : 10 % acétonitril dans 5*10⁻⁴ M d'acide H₂SO₄ aqueux |
| | 10 min : 50 % acétonitril dans 5*10⁻⁴ M d'acide H₂SO₄ aqueux |
| colonne de séparation analytique | 120 x 4 mm |
| volume de préparation V_{präp} | 0,5 ml |
| débit de préparation F_{präp} | 6,5 ml/min |
| déroulement de la préparation t_{präp} | 27 min |
| gradient de solvant ΔAB | linéaire : |
| | 0 min : 10 % acétonitril dans 5*10⁻⁴ M H₂SO₄ aqueux |
| | 25 min : 50 % acétonitril dans 5*10⁻⁴ M H₂SO₄ aqueux |
| | 27 min : 90 % acétonitril dans 5*10⁻⁴ M H₂SO₄ aqueux |
| colonne de séparation de préparation | 250 mm x 16 mm |

4. Procédé de fabrication d'un photosensibilisateur selon la revendication 2,
**caractérisé en ce que**
pour fabriquer le colorant de ruthénium très pur RF2 selon la revendication 1 on utilise les paramètres de procédé et matières suivantes :
| | |
|---|---|
| solvant LM | méthanol pur (le cas échéant avec addition de DMF |
| solvant organique A | acétonitril |
| acide aqueux B | acide sulfurique H₂SO₄ en solution aqueuse |
| adsorbant | gel de silice modifié alkyl |
| volume d'analyse V_{analyt} | 20 µl |
| débit d'analyse F_{analyt} | 1,5ml/min |
| déroulement de l'analyse t_{analyt} | 10 min |
| gradient du solvant ΔAB | linéaire |
| | 0 min : 10 % acêtonitril dans 5*10⁻⁴ M H₂SO₄ aqueux |
| | 10 min : 50 % acétonitril dans 5*10⁻⁴ M H₂SO₄ aqueux |
| colonne de séparation analytique | 120 x 4 mm |
| volume de préparation V_{präp} | 2 ml |
| débit de préparation F_{präp} | 6,5 ml/min |
| déroulement de la préparation t_{präp} | 48 min |
| gradient de solvant ΔAB | linéaire : |
| | 0 min : 20 % acétonitril dans 5*10⁻⁴ M H₂SO₄ aqueux |
| | 45 min : 70 % acêtonitril dans 5*10⁻⁴ M H₂SO₄ aqueux |
| | 46 min : 90 % acétonitril dans 5*10⁻⁴ M H₂SO₄ aqueux |
| | 48 min : 20 % acétonitril dans 5*10⁻⁴ M H₂SO₄ aqueux |
| colonne de séparation de préparation | 250 mm x 16 mm. |

5. Montage pour la mise en oeuvre du procédé selon l'une des revendications 2 à 4 pour la fabrication d'un photosensibilisateur pour les applications industrielles solaires à partir d'une matière première contenant des colorants organiques dont la composition chimique et les propriétés optiques et électroniques correspondent à une palette de colorants organiques chimiquement très voisins mais ayant un effet de sensibilisateur très différent,
**caractérisé en ce qu'**
on dérive la fraction principale (X_{FRAK})_{HAUPT} nécessaire au colorant très pur (X_{PUR}) du photosensibilisateur sensibilisateur dans la fenêtre de rétention caractéristique, dans une position collectrice par une vanne de distribution (VV) commandée manuellement ou automatiquement.

6. Montage pour la mise en oeuvre du procédé selon la revendication 5,
**caractérisé en ce que**
la colonne analytique et de préparation (HPLC) comporte un spectromètre comme détecteur (D) pour la mesure en ligne des spectres d'absorption optiques des fractions respectives (X_{FRAK}) dans le domaine UV et dans le domaine visible.

7. Montage pour la mise en oeuvre du procédé selon la revendication 5 ou 6,
**caractérisé par**
plusieurs colonnes de séparation de préparation qui peuvent être mises en oeuvre par un montage de vannes, de façon décalée par rapport au détecteur (D) dans des fenêtres de rétention caractéristiques.

8. Montage pour la mise en oeuvre du procédé selon la revendication 5 à 7,
**caractérisé en ce que**
comme composants d'automatisation, il est prévu au moins une assistance par calculateur, une commande dans le temps, un échantillonneur automatique et un commutateur à seuil pour la vanne de répartition (VV), permettant d'effectuer le procédé d'une manière cyclique totalement automatique.
